(19) **Europäisches Patentamt / European Patent Office / Office européen des brevets**

(11) **EP 3 798 648 B1**

(12) # FASCICULE DE BREVET EUROPEEN

(45) Date de publication et mention de la délivrance du brevet:
**28.05.2025 Bulletin 2025/22**

(21) Numéro de dépôt: **20198483.8**

(22) Date de dépôt: **25.09.2020**

(51) Classification Internationale des Brevets (IPC):
**G01R 31/08** *(2020.01)* **G01R 31/11** *(2006.01)*
**G01R 31/50** *(2020.01)* **G01R 31/52** *(2020.01)*
**G01R 31/12** *(2020.01)*

(52) Classification Coopérative des Brevets (CPC):
**G01R 31/11; G01R 31/08; G01R 31/085;**
**G01R 31/1272; G01R 31/50; G01R 31/52;**
**Y04S 10/52**

(54) **PROCÉDÉ DE DÉTERMINATION D'UNE POSITION D'UN PRÉCURSEUR DE DÉFAUT DANS UN CÂBLE HAUTE TENSION EN FONCTIONNEMENT**

VERFAHREN ZUR BESTIMMUNG DER POSITION EINER FEHLERVORSTUFE IN EINEM IN BETRIEB BEFINDLICHEN HOCHSPANNUNGSKABEL

METHOD FOR DETERMINING THE POSITION OF A FAULT PRECURSOR IN A HIGH-VOLTAGE CABLE IN OPERATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.09.2019 FR 1910643**

(43) Date de publication de la demande:
**31.03.2021 Bulletin 2021/13**

(73) Titulaires:
• **Electricité de France**
**75008 Paris (FR)**
• **Enedis**
**92800 Puteaux (FR)**

(72) Inventeurs:
• **DIGARD, Hervé**
**77940 LA BROSSE-MONTCEAUX (FR)**
• **ESPILIT, Thierry**
**77250 MORET SUR LOING (FR)**
• **DUBOSCQ, Sylvain**
**77250 VENEUX LES SABLONS (FR)**
• **TAMBRUN, Roger**
**78170 LA CELLE SAINT-CLOUD (FR)**

(74) Mandataire: **Regimbeau**
**20, rue de Chazelles**
**75847 Paris Cedex 17 (FR)**

(56) Documents cités:
**EP-A1- 1 001 271** **EP-A1- 2 618 502**
**EP-A1- 3 223 026** **EP-A2- 0 649 029**
**CN-A- 103 983 901** **CN-A- 105 988 066**
**CN-A- 106 950 445** **FR-A1- 3 032 804**
**JP-A- H05 142 286** **JP-A- S61 225 666**
**US-A- 5 416 418** **US-A- 5 682 100**
**US-A1- 2014 074 414**

• **PETER C J M VAN ET AL: "ON-LINE PARTIAL DISCHARGE DETECTION OF MV CABLES WITH DEFECT LOCALISATION (PDOL) BASED ON TWO TIME SYNCHRONISED SENSORS", 6 June 2005 (2005-06-06), Turin, pages 1 - 5, XP055123588, Retrieved from the Internet <URL:http://www.cired.net/publications/cired2005/papers/cired2005_0456.pdf> [retrieved on 20140616]**

EP 3 798 648 B1

## Description

## DOMAINE DE L'INVENTION

La présente invention concerne le domaine général de la localisation de précurseurs de défaut dans un câble haute tension en fonctionnement.

## ETAT DE LA TECHNIQUE

Les câbles haute tension, typiquement les câbles Haute Tension A (« HTA »), font partie du système de distribution électrique et transmettent un signal Haute Tension triphasé. Le signal haute tension est périodique (typiquement d'une période de 20 millisecondes pour une fréquence de 50Hz) et d'amplitude élevée (typiquement 20 kVolts).

Dans les câbles haute tension, différents types de défaillances dans la conduction électrique peuvent apparaître au cours du temps.

Un premier type de défaillances possible est l'apparition d'un site de décharge partielle qui est un défaut localisé dans l'isolation du câble. Ce site produit une décharge électrique de très faible amplitude qui n'impacte qu'une faible portion de l'isolation. La décharge partielle se produit lorsque le signal haute tension dépasse une valeur de tension dite d'apparition, et s'éteint lorsque la tension redescend sous cette tension d'apparition et qualifiée alors de tension d'extinction. Les décharges partielles peuvent se répéter plusieurs fois par période.

Un deuxième type de défaillance possible est l'apparition d'un précurseur de défaut, appelé aussi « pré-défaut » ou « défaut auto-extincteur ». Ce deuxième type de défaillance est plus grave que l'apparition d'un site de décharge partielle : en effet, lorsque le signal haute tension atteint un certain seuil, généralement au maximum de la tension du réseau, le précurseur de défaut peut générer une décharge totale. Il y a alors une chute brutale de la tension dans le câble à zéro et circulation d'un courant d'amplitude significative dans le défaut. Dans le cas du défaut auto-extincteur, la perturbation s'achève avant la demi-période suivante, et le signal haute tension suit à nouveau la courbe attendue. Cette décharge totale ne se produit pas nécessairement à chaque demi-période du signal haute tension.

Enfin, un troisième type de défaillance est l'apparition d'un défaut franc. Ce troisième type de défaillance est plus grave que les deux précédents. Lorsque le signal haute tension atteint un certain seuil, le défaut franc produit une décharge totale. Il y a alors une chute brutale de la tension dans le câble à zéro. La perturbation dure plusieurs demi-périodes successives sans interruption. La perturbation conduit dans ce cas à l'ouverture du disjoncteur de protection sur la liaison haute tension pour mettre un terme à la perturbation.

Si aucune intervention n'est menée sur le câble, un site de décharge partielle peut, au bout d'un certain temps, devenir un précurseur de défaut puis finalement devenir un défaut franc.

Par conséquent, il est important de surveiller les câbles haute tension afin d'en estimer l'état de santé et d'intervenir avant l'apparition du défaut franc.

Il existe des procédés de détection et de localisation de défaillance dans la conduction électrique du câble haute tension. Certains procédés de détection (qualifiés de procédés « on-line ») sont mis en œuvre alors que le câble haute tension est « en fonctionnement ». Un câble haute tension est « en fonctionnement » lorsqu'il est connecté au reste du réseau de distribution et qu'il est alimenté par le signal haute tension du réseau de distribution.

D'autres procédés de détection (qualifiés de procédés « off-line ») requièrent que le câble haute tension soit « hors fonctionnement », c'est-à-dire qu'il soit isolé du reste du réseau de distribution. L'intervention d'une équipe de techniciens est alors nécessaire sur site pour réaliser une déconnexion du câble et mener les tests avec une alimentation électrique dédiée.

Pour surveiller les câbles haute tension et estimer leur état de santé, les procédés de détection et de localisation de défaillance du câble haute tension « on-line » présentent l'avantage de ne pas mobiliser une équipe de techniciens, de ne pas être limités temporellement à la durée de l'intervention de l'équipe et de poursuivre la distribution électrique en utilisant tous les câbles haute tension du système de distribution électrique.

Parmi les procédés « on-line » de détection et de localisation d'un site de décharge partielle dans un câble haute tension, on connaît des procédés qui utilisent des transpondeurs. Un transpondeur est un dispositif capable d'envoyer un signal après un temps d'activation prédéfini.

Par exemple, un procédé de détection et de localisation d'un site de décharge partielle peut suivre la chronologie suivante. Lorsqu'une décharge partielle se produit dans un câble haute tension qui relie deux postes Haute Tension A / Basse Tension (« HTA/BT »), deux impulsions électriques sont générées à partir du site de décharge et se propagent en sens inverses chacune vers un poste HTA/BT respectif. A un premier poste HTA/BT, une première impulsion est détectée. Cela active un transpondeur qui envoie un signal témoin vers le deuxième poste HTA/BT. Le temps d'activation du transpondeur est de l'ordre de 100 µs. Au deuxième poste HTA/BT, sont détectés successivement une impulsion directe générée par la décharge partielle, puis le signal témoin. Un calcul est ensuite mené à partir des mesures des deux instants de détection de l'impulsion directe et du signal témoin, et du temps d'activation du transpondeur, pour déterminer la localisation de la décharge partielle.

Cependant, un tel procédé de détection et de localisation ne concerne que les sites de décharge partielle, et n'est pas adapté à la détection et la localisation de précurseurs de défaut.

En effet, la perturbation électrique due à un précurseur de défaut est trop importante pour permettre la détection du signal témoin.

L'art antérieur comprend les documents US 5 682 100 A, US 5 416 418 A et JP S61-225666 A divulguant chacun un procédé de détermination d'une position d'un défaut dans un câble haute-tension reliant un premier poste et un deuxième poste.

On connaît par ailleurs des procédés de détection et de localisation de précurseurs de défaut. Ces procédés nécessitent généralement une synchronisation temporelle d'horloges dans les postes HTA/BT, et utilisent pour ce faire des systèmes GPS ou GSM. Ces procédés présentent toutefois un certain nombre de désavantages.

D'une part, pour les procédés de détection utilisant des systèmes GPS, les difficultés de captation d'un signal GPS en milieu urbain rendent leur application plus difficile en ville et limitent leur intérêt pour les utiliser sur les réseaux de distribution d'électricité. Pour obtenir une précision dans la localisation du précurseur de défaut, il faut des oscillateurs très haute stabilité et donc couteux à l'achat.

D'autre part, les procédés de détection utilisant des systèmes GSM sont tributaires du bon fonctionnement de la liaison GSM. Le traitement des informations est lié à un abonnement auprès du fournisseur entraînant un surcout d'abonnement lié au nombre de liaisons à surveiller, et le fait que le fournisseur a accès aux données de l'opérateur de réseau.

Il existe donc un besoin pour un procédé « on-line » de détection et de localisation de précurseurs de défaut dans un câble haute tension, qui ne nécessite pas l'utilisation de systèmes de synchronisation complexes.

## EXPOSE DE L'INVENTION

Un but général de l'invention est de proposer un procédé de détection et de localisation de précurseurs de défaut dans un câble haute tension en fonctionnement, qui ne nécessite pas l'utilisation de systèmes de synchronisation complexes.

Le but est atteint dans le cadre de la présente invention grâce à un procédé de détermination d'une position d'un précurseur de défaut dans un câble haute tension détérioré reliant un premier poste et un deuxième poste, l'un du premier poste et du deuxième poste étant un poste source propre à alimenter le câble haute tension avec un signal haute tension et l'autre du premier poste et du deuxième poste étant un poste secondaire propre à recevoir le signal haute tension, comprenant les étapes suivantes

une étape S1 détection par le premier poste d'une première signature d'une anomalie de courant électrique dans le signal haute tension,

une étape S2 détection par le deuxième poste d'une deuxième signature de l'anomalie de courant électrique dans le signal haute tension,

une étape S3 d'émission par le deuxième poste d'un signal témoin vers le premier poste dans le câble haute tension, le signal témoin étant émis par le deuxième poste avec un retard prédéterminé à compter d'un instant de détection de la deuxième signature, le retard prédéterminé prenant une valeur comprise entre 15% et 50% de la période du signal haute-tension,

une étape S4 de détection par le premier poste du signal témoin reçu par le premier poste,

une étape S5 de détermination de la position du précurseur de défaut dans le câble haute tension, en fonction d'un instant de détection de la première signature par le premier poste et d'un instant de détection du signal témoin par le premier poste.

Grâce à l'émission par le deuxième poste du signal témoin vers le premier poste, le procédé proposé ne nécessite pas d'utiliser un système de synchronisation.

De plus, grâce à la valeur particulière du retard avec lequel est émis le signal témoin, celui-ci peut être détecté sans être noyé dans une perturbation électrique due au précurseur de défaut. En effet, le retard est d'une part suffisamment important pour que le signal témoin soit envoyé après la fin de la perturbation électrique, et d'autre part suffisamment faible pour que le signal témoin soit envoyé avant la demi-période suivante où une nouvelle perturbation électrique pourrait avoir lieu.

Un tel procédé est avantageusement complété par les différentes caractéristiques ou étapes suivantes prises seules ou en combinaison :

le câble haute tension comprend trois phases, l'étape de détection par le premier poste d'une première signature comprenant la mesure de trois signaux électriques alimentant les trois phases, le calcul de la somme des mesures des trois signaux électriques et la comparaison de la somme à un seuil ;

le premier poste est relié à une pluralité de deuxièmes postes via une pluralité de câbles haute tension, chaque câble étant alimenté par un même signal haute tension, l'étape de détection de la première signature comprenant les sous-étapes suivantes :

une étape S1A de détection par le premier poste d'une pluralité de premières signatures de l'anomalie de courant électrique dans les signaux haute tension, une étape S1B d'identification, parmi les premières signatures, de la première signature principale représentative d'une irrégularité de courant d'amplitude maximale, de variation initiale maximale et opposée aux autres premières signatures d'irrégularité de courant,

une étape S1C d'identification, parmi la pluralité de câble haute tension, du câble haute tension détérioré alimenté par le signal haute tension comportant la première signature principale identifiée, et

dans lequel la position du précurseur de défaut est déterminée dans le câble haute tension détérioré par la mise en œuvre des étapes S1 à S5 avec la première signature principale comme première signature ;

le premier poste est relié à une pluralité de deuxièmes postes via une pluralité de câbles haute tension, chaque câble étant alimenté par un même signal haute tension, et les deuxièmes postes sont configurés pour émettre chacun un signal témoin avec une caractéristique prédéterminée qui diffère de caractéristiques prédéterminées des signaux témoins émis par les autres deuxièmes postes, le procédé comprenant, après l'étape S4 de détection par le premier poste du signal témoin reçu par le premier poste, les étapes additionnelles :

une étape P1 de détection de la caractéristique prédéterminée du signal témoin,
une étape P2 de détermination d'une position possible du précurseur de défaut dans le câble haute tension, en fonction d'un instant de détection de la première signature par le premier poste et d'un instant de détection du signal témoin par le premier poste.,
l'étape S5 de détermination de la position du précurseur de défaut dans le câble haute tension prenant en compte pour chaque signal témoin reçu la position possible du précurseur de défaut dans le câble haute tension ;
la caractéristique prédéterminée est choisie parmi une valeur particulière de retard, une répartition temporelle entre plusieurs impulsions formant le signal témoin, ou une combinaison de ces caractéristiques ;

L'invention porte également sur un premier dispositif de détermination de la position d'un précurseur de défaut dans un câble haute tension détérioré reliant deux postes, comprenant

un premier système d'acquisition et de traitement de signal haute-tension passant dans le câble haute tension, le premier système d'acquisition et de traitement étant adapté pour détecter une signature d'une anomalie de courant et un signal témoin, et

un premier système de décompte du temps contrôlé par le premier système d'acquisition et de traitement.

Avantageusement, mais facultativement, le premier système d'acquisition et de traitement du premier dispositif peut être adapté pour détecter une pluralité de signatures d'une anomalie de courant passant dans une pluralité de câbles haute tension tous reliés à l'un des deux postes, chaque câble étant alimenté par un signal haute tension respectif, et adapté pour détecter parmi cette pluralité de signatures une signature d'irrégularité de courant d'amplitude maximale, de variation initiale maximale et opposée aux autres signatures d'irrégularité de courant.

L'invention porte enfin sur un deuxième dispositif de détermination de la position d'un précurseur de défaut dans un câble haute tension détérioré reliant deux postes, comprenant un détecteur d'impulsion électromagnétique, un appareil pour générer et injecter un signal témoin dans le câble haute tension, le deuxième dispositif e détermination étant adapté pour que la détection d'une impulsion électromagnétique par le détecteur d'impulsion électromagnétique déclenche l'injection d'un signal témoin par l'appareil après un délai précis.

Avantageusement, mais facultativement, l'appareil du deuxième dispositif peut être configuré pour émettre un signal témoin avec une caractéristique prédéterminée parmi une valeur particulière de retard, de préférence comprise entre 15% et 50% de la période du signal haute-tension, une répartition temporelle entre plusieurs impulsions formant le signal témoin, ou une combinaison de ces caractéristiques.

## DESCRIPTION DES FIGURES

D'autres caractéristiques et avantages de l'invention ressortiront encore de la description qui suit, laquelle est purement illustrative et non limitative, et doit être lue en regard des dessins annexés sur lesquels :

[Fig. 1] la figure 1 représente schématiquement une structure générale d'un départ HTA d'un poste source alimentant un câble haute tension.
[Fig. 2] la figure 2 représente schématiquement un signal témoin.
[Fig. 3] la figure 3 représente schématiquement un procédé de détection et de localisation d'un précurseur de défaut conforme à un mode de réalisation de l'invention.
[Fig. 4] la figure 4 représente schématiquement une frise temporelle des étapes et des évènements qui se produisant au cours un procédé de détection et de localisation d'un précurseur de défaut conforme à un mode de réalisation de l'invention.
[Fig. 5] la figure 5 représente schématiquement une structure générale d'un départ HTA d'un poste source alimentant une pluralité de câbles haute tension.

## DESCRIPTION DETAILLEE DE L'INVENTION

*Structure générale d'un départ HTA d'un poste source alimentant une liaison souterraine d'un réseau de distribution*

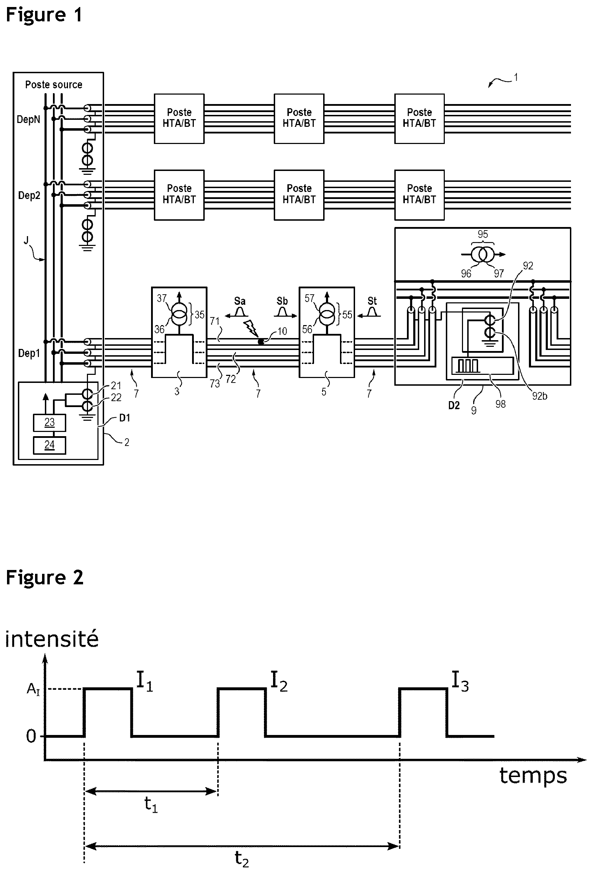

La figure 1 représente une structure générale 1 de plusieurs départs HTA Dep1, Dep2, DepN à partir d'un poste source 2 alimentant une pluralité de liaisons souterraines d'un réseau de distribution.

La partie 1 du système de distribution électrique comprend un poste source 2 dans lequel un jeu J de trois barres est alimenté par un signal haute tension triphasé.

*Câble haute tension*

Depuis le départ Dep1 part un câble haute tension 7 qui relie une pluralité de postes HTA/BT 3, 5, 9.

Le câble haute tension 7 est formé de trois phases haute tension 71, 72, 73 et est alimenté par un signal haute tension triphasé.

Le câble haute tension 7 peut être souterrain en partie ou en totalité.

Les phases haute tension 71, 72, 73 unipolaires des réseaux de distribution présentent chacune une structure coaxiale constituée de trois parties : une âme conductrice, un isolant diélectrique qui entoure l'âme conductrice et un écran métallique qui entoure l'isolant.

L'isolant diélectrique est soit de nature synthétique, comme par exemple le polyéthylène, soit à base de papier imprégné pour les technologies les plus anciennes.

La structure coaxiale des câbles est assimilable à une ligne de transmission et les phénomènes transitoires qui affectent la liaison comme par exemple les défaillances dans la conduction électrique (décharges partielles, précurseurs de défaut) génèrent des ondes électromagnétiques qui se propagent dans les câbles.

La vitesse de propagation des phénomènes transitoires dépend de la nature du diélectrique. Pour les câbles usuellement utilisés, la vitesse de propagation des ondes varie entre 150 et 180 m/$\mu$s.

En amont de la mise en œuvre du procédé de détection, la vitesse de propagation Vp des phénomènes transitoires dans le câble haute tension 7 est déterminée.

Le câble haute tension 7 relie d'une part le poste source 2 à une première extrémité du câble haute tension 7 et d'autre part un poste HTA/BT final 9 à une deuxième extrémité du câble haute tension 7.

En amont de la mise en œuvre du procédé de détection, la longueur L du câble haute tension 7 entre ces deux extrémités est identifiée. Cette longueur L vaut classiquement entre 2 et 10 kilomètres.

En cas de défaillance dans la conduction électrique jugée suffisamment grave, il est nécessaire de réaliser une intervention sur site pour remplacer le câble haute tension 7 ou une partie du câble haute tension 7 (par exemple une jonction). Le câble remplacé ou la partie du câble remplacée comprend les trois phases haute tension 71, 72, 73. Il n'est donc pas nécessaire de déterminer sur quelle phase 71, 72 et 73 se situe la défaillance dans la conduction électrique.

*Poste source*

Un poste source ou poste HTB/HTA permet d'abaisser la tension électrique en vue de son acheminement vers les utilisateurs. Grâce à un transformateur HTB/HTA, la tension électrique peut être abaissés dans le poste source par exemple de 225 000 volts (Haute tension de type B) en 20 000 volts (Haute tension de type A).

Une sortie tension de type A d'un transformateur HTB/HTA alimente un jeu J de trois barres. Une pluralité de départs HTA Dep1, Dep2... DepN est connectée au jeu J de barres. Chaque départ HTA alimente un câble haute tension en triphasé. Le départ HTA Dep1 alimente le câble haute tension 7. Classiquement le poste source 2 peut alimenter jusqu'à 30 câbles haute tension en triphasé. Le poste source comprend typiquement deux transformateurs HTB/HTA. Chaque transformateur alimente un ensemble de départs HTA représentant environ la moitié des départs HTA du poste source.

Le poste source 2 comprend un premier dispositif D1 de détermination de la position d'un précurseur de défaut.

Le premier dispositif D1 comprend un système d'acquisition et de traitement 23.

Le système d'acquisition et de traitement 23 comprend un ou plusieurs détecteurs d'impulsion électromagnétique, comme un tore de courant 21, un capteur de courant à haute fréquence 22 ou un tore Haute Fréquence.

Le système d'acquisition et de traitement 23 comprend suffisamment de détecteurs pour mesurer les phénomènes transitoires :

en intensité sur chacun des câbles haute tension qui sont alimentés par le poste source 2, et
en tension pour chaque transformateur HTB/HTA du poste source connecté à un ensemble de départs HTA.

Le ou les détecteurs peuvent être placés dans la mise à la terre commune des écrans des câbles du départ du ou des câbles haute tension.

Le système d'acquisition et de traitement 23 est adapté pour reconnaître des phénomènes transitoires comme par exemple des anomalies de courant dues à un précurseur de défaut ou bien une série d'impulsions électriques.

Le dispositif de détermination D1 est adapté, lors de la détection d'un phénomène transitoire pour mesurer la valeur du signal haute tension dans la phase du câble haute tension où le phénomène transitoire est détecté.

Le premier dispositif D1 comprend un système de décompte du temps 24 contrôlé par le système d'acquisition et de traitement 23. L'instant de détection des phénomènes transitoires par le système d'acquisition et de traitement 23 peut ainsi être déterminé.

Le système d'acquisition et de traitement 23 comprend également une mémoire afin d'enregistrer des données, comme par exemple les instants de détection ou d'autres caractéristiques des phénomènes transitoires détectés.

*Postes HTA/BT intermédiaires*

Le câble haute tension 7 passe par une pluralité de postes HTA/BT 3, 5 (Haute tension de type A/ Basse Tension par exemple 230 Volts) qui sont répartis en série sur le câble haute tension 7.

Chaque poste HTA/BT comprend un transformateur HTA/BT 35, 55 connecté à la liaison souterraine 7 via un interrupteur. Le transformateur 35,55 comprend un primaire 36, 56 alimenté par le triphasé du câble haute tension, et un secondaire 37, 57 qui distribue l'énergie vers les abonnés.

*Poste HTA/BT en extrémité du câble haute tension*

Le poste HTA/BT final 9 comprend un transformateur HTA/BT 95 qui comprend lui-même un primaire 96 et un secondaire 97 similaire à celui qui a été décrit pour les autres postes HTA/BT 3 et 5.

Le poste HTA/BT final 9 comprend un deuxième dispositif D2 de détermination de la position d'un précurseur de défaut.

Le deuxième dispositif D2 comprend au moins un détecteur 92 d'impulsion électromagnétique, comme un capteur de courant à haute fréquence.

Le deuxième dispositif D2 comprend suffisamment de détecteurs pour mesurer les phénomènes transitoires arrivant par le câble haute tension, en tension ou en intensité.

Le ou les détecteurs peuvent être placés dans la mise à la terre commune des écrans du câble haute tension 7.

Le deuxième dispositif D2 comprend également un appareil 98 pour générer et injecter un signal témoin dans le câble haute tension 7.

Le signal peut être injecté au moyen du détecteur 92 ou d'un tore 92b. Le deuxième dispositif D2 est adapté pour que la détection d'une impulsion électromagnétique par le détecteur 92 d'impulsion électromagnétique déclenche l'injection d'un signal témoin par l'appareil 98 après un délai précis. La précision sur le délai est typiquement de l'ordre d'une dizaine de nanosecondes.

L'appareil 98 peut être un système répétiteur ou un système transpondeur.

Le signal témoin généré par l'appareil 98 peut être une série d'impulsions.

Il est possible de paramétrer l'appareil 98 avant son installation dans le poste HTA/BT pour que le signal témoin comporte deux ou trois impulsions voire davantage.

Comme représenté sur la figure 2, un signal témoin $S_T$ peut être composé de trois impulsions créneaux $I_1$, $I_2$ et $I_3$.

Les impulsions créneaux $I_1$, $I_2$ et $I_3$ peuvent présenter toutes la même amplitude $A_I$.

L'amplitude des impulsions injectées par l'appareil 98 dans le câble haute tension 7 vaut typiquement quelques ampères

L'appareil 98 est adapté pour que le front montant d'une impulsion générée s'étale temporellement sur une durée aussi courte que quelques nanosecondes. Les durées entre le front montant d'une impulsion créneau et de l'impulsion créneau suivante ne sont pas nécessairement égales.

Plus généralement, il est possible de paramétrer l'appareil 98 pour faire varier les durées $t_1$ (respectivement $t_2$) écoulées entre le front montant de la première impulsion créneau $I_1$ et le front montant des impulsions créneaux suivantes $I_2$ (respectivement $I_3$). Ces durées sont choisies au moins égales à plusieurs dizaines de microsecondes, par exemple 50 microsecondes.

*Procédé de détermination et de localisation du précurseur de défaut*

Le câble haute tension 7 alimente en triphasé l'ensemble des différents postes HTA/BT 3, 5, 9 de façon à distribuer l'énergie électrique vers les abonnés.

Dans l'exemple illustré sur la figure 1, un précurseur de défaut 10 est présent sur une des phases haute-tension du câble haute tension 7.

A un instant ti où la tension dans la phase haute tension 71 dépasse en valeur absolue un certain seuil, une décharge totale se produit au niveau du précurseur de défaut.

Cela crée une perturbation électrique ou anomalie de courant électrique dans le signal haute tension passant dans le câble haute tension 7.

La perturbation électrique génère deux impulsions électriques qui se propagent en sens inverses dans le câble haute tension 7 :

- une première impulsion électrique Sa qui se propage depuis le précurseur de défaut 10 vers le poste source 2 à la première extrémité du câble haute tension 7, et
- une deuxième impulsion électrique Sb qui se propage depuis le précurseur de défaut 10 vers le poste HTA/BT final 9 à la deuxième extrémité du câble haute tension 7.

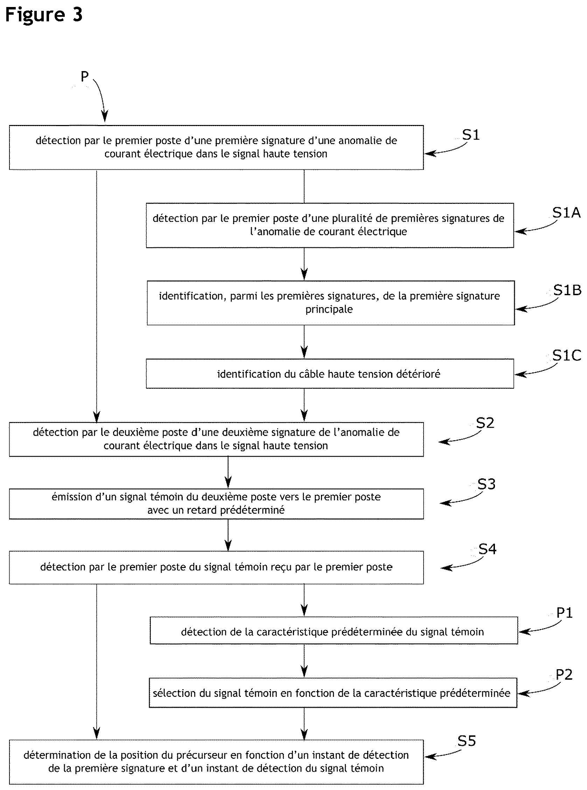

Le système d'acquisition et de traitement 23 est configuré pour mettre en œuvre un procédé de détermination d'une position du précurseur de défaut dans le câble haute tension détérioré en suivant les étapes illustrées sur la figure 3.

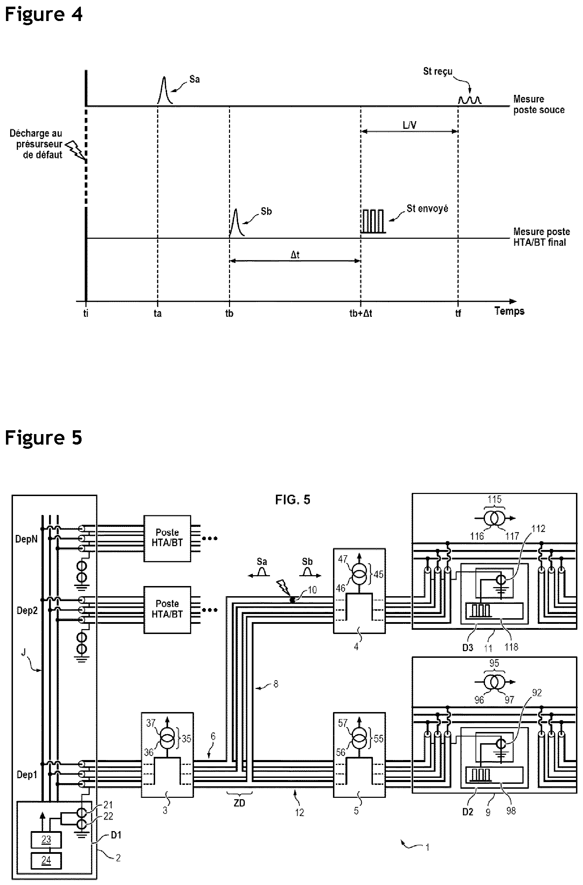

La figure 4 est une frise temporelle des évènements qui se produisent au cours du procédé.

Au cours d'une première étape S1, le système d'acquisition et de traitement 23 du premier dispositif D1 détecte la première impulsion Sa. Le système d'acquisition et de traitement 23 comprend en effet suffisamment de détecteurs pour mesurer les phénomènes transitoires.

Simultanément à la propagation de la première impulsion électrique Sa, la deuxième impulsion Sb se propage vers le poste HTA/BT final 9 ce qui déclenche l'étape S2 présentée ci-après. Il est à noter que selon la position du précurseur de défaut, la première impulsion Sa peut arriver au poste source 2 avant ou après que la deuxième impulsion arrive au poste HTA/BT final 9.

L'ordre de ces étapes S1 et S2 n'est donc pas fixe d'une configuration à une autre dans la mise en œuvre du procédé.

Grâce au dispositif D1 placé au poste source 2, la détection de la première impulsion électrique Sa permet de trouver une première signature de l'anomalie de courant électrique dans le signal haute tension, à savoir la décharge totale due au précurseur de défaut.

Le système de décompte du temps 24 permet d'associer un instant ta de détection à la première impulsion électrique Sa. La mesure de la première impulsion électrique Sa et son instant ta de détection peuvent être enregistrées par le système d'acquisition et de traitement 23.

La première impulsion électrique Sa mesurée dans le premier dispositif D1, au moyen d'un tore Haute Fréquence présente typiquement une étendue temporelle inférieure à un quart de période du signal haute tension.

Dans le cas d'un signal de pré-défaut, l'étendue temporelle de la première impulsion électrique Sa vaut typiquement 3 millisecondes .

Dans le cas où le poste source 2 alimente plusieurs câbles haute tension, il est obtenu pour chaque câble haute tension une première signature de l'anomalie de courant dans le signal haute tension associé. La défaillance de conduction électrique dans un câble haute tension influence en effet les autres câbles haute tension.

Il est alors nécessaire de comparer les différentes premières signatures de l'anomalie pour déterminer dans quel câble haute tension se situe le précurseur de défaut.

Au cours d'une étape S1A, le système d'acquisition et de traitement 23 détecte les différentes premières signatures mesurées pour chacun des câbles haute tension. Ces différentes premières signatures peuvent être enregistrées par le système d'acquisition et de traitement 23.

Au cours d'une étape S1B, une recherche parmi ces premières signatures est menée par le système d'acquisition et de traitement 23. Il est identifié au cours de cette étape S1B la première signature représentant l'irrégularité de courant de plus grande amplitude, de plus grande variation initiale, et dont la variation est opposée, c'est-à-dire de signe opposé, aux variations de courant représentées dans les autres premières signatures.

Au cours d'une étape S1C, le système d'acquisition et de traitement 23 détermine dans quel câble haute tension le précurseur de défaut se situe, c'est le câble haute tension pour lequel a été obtenu la première signature identifiée durant l'étape S1B.

La première signature obtenue en effet pour le câble haute tension comportant le précurseur de défaut présente en effet :

- la plus forte amplitude de variation en intensité - plus précisément cette plus forte amplitude est proche de la somme des amplitudes des premières signatures des autres câbles connectés au poste source 2 - ;
- une variation de courant de polarité inverse de celle des autres premières signatures ;
- une pente initiale dans la variation de courant plus importante que celle des autres premières signatures.

Au cours de l'étape S1C, le système d'acquisition et de traitement 23 peut également enregistrer dans la mémoire l'instant ta où la première impulsion électrique Sa a été détectée au poste source 2 et la mesure de cette impulsion Sa.

Il est à noter que la détection de la première impulsion électrique Sa peut être complétée par une étape de confirmation de la nature de la défaillance dans la conduction.

Au cours de l'étape S1, le système d'acquisition et de traitement 23 peut mesurer les trois signaux électriques alimentant les trois phases haute tension 71, 72, 73.

Le dispositif de détermination D1 est en effet adapté, lors de la détection d'un phénomène transitoire pour mesurer la valeur du signal haute tension dans la phase du câble haute tension où le phénomène transitoire est détecté.

Le dispositif de détermination calcule la somme des trois tensions mesurées au poste source 2 dans les phases. Si la somme des trois tensions est supérieure à un seuil identifié, alors il s'agit d'une défaillance de type décharge totale.

La comparaison de la somme au seuil permet de s'assurer que la perturbation détectée est un évènement anormal que l'on souhaite étudier, tel qu'une décharge totale due à un précurseur de défaut, et non pas un évènement anodin tel qu'un changement de charge sur le réseau.

Au cours d'une étape S2, le détecteur 92 d'impulsion électromagnétique du deuxième dispositif D2 détecte la deuxième impulsion Sb.

Grâce au dispositif D2 placé au poste HTA/BT final 9, la détection de la deuxième impulsion électrique Sb permet de trouver une deuxième signature de l'anomalie de courant électrique dans le signal haute tension, à savoir la décharge totale due au précurseur de défaut.

La détection de la deuxième impulsion électrique Sb est effectuée à un instant tb de détection.

Au cours d'une étape S3, l'appareil 98 émet dans le câble haute tension 7 un signal témoin St.

Le signal témoin St est émis après un certain délai ou retard Δt écoulé à partir de l'instant de détection tb de la deuxième impulsion Sb par le système transpondeur 98.

Le retard Δt est choisi égal à une valeur comprise entre 15% et 50% de la période du signal haute-tension. Comme évoqué plus haut cela correspond dans le cas d'un signal haute tension de fréquence 50 Hz à un retard Δt compris entre 3 millisecondes et 10 millisecondes.

Le retard Δt est prédéterminé en amont de la mise en œuvre du procédé de détection et paramétré dans le transpondeur. La valeur du retard Δt est enregistrée dans la mémoire du système d'acquisition et de traitement 23.

Le signal témoin St consiste en une série d'impulsions créneaux, par exemple trois impulsions, telle qu'on a pu les décrire précédemment en rapport avec la figure 2.

Le signal témoin St se propage et parvient au poste source 2. Compte tenu de la longueur L importante du câble haute tension 7, le signal témoin St est fortement atténué au cours de la propagation. Pour une amplitude de plusieurs dizaines de Volts du signal témoin envoyé depuis le poste HTA/BT final 9, il est reçu au poste source 2 un signal témoin d'amplitude de quelques dizaines ou centaines de milliVolts selon la distance séparant le poste 9 et le poste source. Au cours d'une étape S4, le signal témoin St est détecté au sein du premier dispositif D1 du poste source 2.

La mesure du signal témoin St et son instant tf de détection peuvent être enregistrées dans la mémoire par le système d'acquisition et de traitement 23.

Au cours d'une étape S5, le système d'acquisition et de traitement 23 procède à la détermination de la position du précurseur de défaut 10 dans le câble haute tension 7.

Pour établir cette position, le système d'acquisition et de traitement 23 prend en compte les informations suivantes :

- l'instant de détection ta de la première impulsion Sa,
- l'instant de détection tf du signal témoin,
- le retard Δt enregistré dans la mémoire du système d'acquisition et de traitement 23,
- la vitesse de propagation Vp des phénomènes transitoires dans le câble haute tension 7 prédéterminée et enregistrée dans la mémoire du système d'acquisition et de traitement 23, et

- la longueur L du câble haute tension 7 prédéterminée et enregistrée dans la mémoire du système d'acquisition et de traitement 23.

A partir de ces différentes informations, la distance D séparant le poste source 2 et le précurseur de défaut 10 peut être calculée selon la relation suivante:

$$D = 0.5 \times [L - V \times (tf - ta - (L/V) - \Delta t)]$$

Ou encore

$$D = L - 0.5 \times V \times [tf - ta - \Delta t].$$

*Effets techniques et avantages*

Le procédé de détermination de la position du précurseur de défaut 10 dans le câble haute tension 7 tel qu'on vient de le présenter fait intervenir un retard contrôlé Δt.

Ce retard contrôlé à l'envoi du signal témoin St par le deuxième dispositif est égal ou proche de la durée de la première impulsion électrique Sa et de la deuxième impulsion électrique Sb. Cette durée correspond au temps typique de perturbation électrique du câble haute tension 7 due à la décharge totale produite au précurseur de défaut 10.

Cette perturbation peut être importante, les variations en intensité mesurées pouvant atteindre le kilo-Ampère, notamment en tout début de perturbation électrique.

Mesurer un signal témoin St émis par le deuxième dispositif D2 qui arriverait au premier dispositif D1 avant quelques millisecondes, typiquement 2 ou 3 millisecondes serait difficile car le signal témoin serait noyé par la perturbation.

En imposant un retard d'au moins 3 millisecondes, le signal témoin St part du deuxième dispositif D2 et arrive au premier dispositif D1 après que l'essentiel de la composante haute fréquence de la perturbation électrique soit amortie. Cela permet un bien meilleur rapport signal sur bruit dans la détection du signal témoin par le premier dispositif D1.

Il est à noter qu'imposer un retard supérieur à 50% de la période du signal haute tension, par exemple 10 millisecondes pour une fréquence de 50 Hz, implique que le signal témoin est envoyé à la demi-période suivante. Or, à la demi-période suivante la tension du signal haute tension est à nouveau suffisamment différente de zéro pour déclencher une décharge totale du précurseur de défaut 10, ou déclencher une autre défaillance dans la conduction électrique du câble haute tension. Le risque que le signal témoin soit noyé dans une autre perturbation électrique est important, de sorte qu'un retard supérieur à 50% de la période du signal haute tension ne présente pas un intérêt majeur.

Il devient ainsi possible de proposer un procédé de détection et de localisation de précurseurs de défaut dans un câble haute tension en fonctionnement.

Par ailleurs le procédé proposé ne fait pas appel à la synchronisation temporelle d'horloges situées aux extrémités du câble haute tension 7.

*Adaptation du procédé lorsque le poste source alimente plusieurs câbles haute tension ou alimente des câbles haute tension en dérivation*

Dans le cas où le poste source 2 alimente une pluralité de câbles ou des câbles haute tension en dérivation, il est possible d'adapter le procédé de détermination de la position du précurseur de défaut.

La figure 5 illustre cette situation dans le cas de deux câbles haute tension en dérivation. Les éléments de la figure 5 qui présentent la même numérotation que dans la figure 1 sont identiques aux éléments de la figure 1 tels qu'on a pu les présenter plus haut dans la description.

La portion de réseau électrique illustrée dans la figure 5 présente un câble haute tension 6 au niveau du poste source 2. Au sein d'une zone $Z_D$ de dérivation, le câble haute tension est séparée en deux câbles haute tension 8 et 12 qui se trouvent donc en dérivation.

Chaque câble haut tension 6, 8 et 12 est alimenté par un signal haute tension de type triphasé.

Le câble haute tension 8 alimente un poste HTA/BT 4 et un deuxième poste HTA/BT final 11 en extrémité de câble haute tension 8.

Ces deux postes HTA/BT 4 et 11 comprennent un transformateur 45, 115 comprenant lui-même un primaire 46, 116 et un secondaire 47, 117 similaires à ceux décrits pour les autres postes HTA/BT 3, 5 et 9. Le câble haute tension 8 peut alimenter une pluralité de postes HTA/BT répartis en série entre la zone $Z_D$ de dérivation et le deuxième poste HTA/BT final 11.

Le deuxième poste HTA/BT final 11 en extrémité de câble haute tension 8 comprend un troisième dispositif D3 de détermination de la position d'un précurseur de défaut, similaire au deuxième dispositif D2 présenté précédemment.

Le troisième dispositif D3 comprend notamment :

- au moins un détecteur 112 d'impulsion électromagnétique,
- un appareil 118 pour générer et injecter un signal témoin dans le câble haute tension 8.

Le premier appareil 98 et le deuxième appareil 118 sont configurés pour que les signaux témoin qu'ils émettent présentent une ou plusieurs caractéristiques différentes.

Cette caractéristique peut être :

- une valeur particulière de retard : le premier retard $\Delta t$ du premier appareil 98 est choisi pour être différent du deuxième retard $\Delta t2$ du deuxième appareil 118,
- un nombre d'impulsions formant le signal témoin : le premier appareil 98 peut produire un signal témoin comportant trois impulsions et le deuxième appareil peut produire un signal témoin comportant quatre impulsions,
- une répartition temporelle entre les impulsions formant le signal témoin : les durées écoulées entre le front montant de la première impulsion créneau et le front montant des impulsions créneaux suivantes formant le signal témoin peuvent différer entre le signal témoin émis par le premier appareil et le deuxième appareil, et
- une combinaison possible entre ces caractéristiques.

Ces caractéristiques sont choisies pour être reconnues par le système d'acquisition et de traitement 23 lors de la détection du signal témoin, même après que le signal témoin ait parcouru toute la longueur d'un câble haute tension.

Il est possible d'enregistrer en amont de la mise en œuvre du procédé de détection dans la mémoire du système d'acquisition et de traitement 23 du poste source 2 quelles caractéristiques de signal témoin sont choisies pour quel appareil.

D'une manière générale, dans le cas où le poste source 2 alimente une pluralité de câbles ou des câbles haute tension en dérivation, il existe une pluralité de postes HTA/BT finaux en extrémité de lignes. Dans chacun de ces postes finaux, il est possible de placer un dispositif de détermination de la position d'un précurseur de défaut dont l'appareil est configuré pour émettre un signal témoin dont les caractéristiques sont différentes de tous les autres signaux témoins émis par les autres appareils. Comme dans le cas précisé plus haut, il est possible d'enregistrer en amont de la mise en œuvre du procédé de détection dans la mémoire du système d'acquisition et de traitement 23 du poste source 2 quelles caractéristiques de signal témoin sont choisies pour quel appareil.

Si un précurseur de défaut 10 est présent sur une des phases haute-tension du câble haute tension 8, il est possible à un certain instant de fonctionnement du réseau de distribution électrique, qu'une décharge totale se produise au niveau du précurseur de défaut 10.

La figure 5 illustre un exemple où le précurseur de défaut 10 se situe sur le câble haute tension 8 entre la zone $Z_D$ de dérivation et le deuxième poste HTA/BT final 11.

Une première impulsion électrique Sa se propage vers le poste source 2. Lorsque cette première impulsion Sa parvient dans la zone $Z_D$ de dérivation, une première partie de l'impulsion électrique Sa se propage vers le poste source 2. La détection de cette première partie de l'impulsion électrique au poste source 2 suit les étapes décrites précédemment.

Une deuxième partie de la première impulsion électrique Sa se propage vers le premier poste HTA/BT final 9. Le dispositif D2 détecte la deuxième partie de l'impulsion électrique Sa et un premier signal témoin est émis vers le poste source 2 par le premier appareil 98.

Une deuxième impulsion électrique Sb se propage vers et parvient au deuxième poste HTA/BT final 11. Le dispositif D3 détecte la deuxième impulsion et un deuxième signal témoin est émis vers le poste source 2 par le deuxième appareil 118.

Le premier signal témoin et le deuxième signal témoin parviennent au poste source 2, où ils sont détectés.

Au cours d'une étape P1, il est procédé à la détection de la caractéristique prédéterminée, ou des caractéristiques prédéterminées de chaque signal témoin reçu.

Le signal témoin a des caractéristiques particulières, en termes de forme et de retard Δt, qui sont en effet enregistrées dans la mémoire du système d'acquisition et de traitement 23. Ces caractéristiques peuvent donc être reconnues par le système d'acquisition et de traitement 23, de sorte qu'il est possible de garantir l'origine d'un signal témoin.

Au cours d'une étape P2, une position possible du précurseur de défaut dans le câble haute tension est déterminée pour chaque signal témoin reçu. Comme précédemment, la détermination utilise l'instant de détection de la première signature par le premier poste et l'instant de détection du signal témoin par le premier poste. Il est sélectionné dans la mémoire du système d'acquisition et de traitement 23, les informations nécessaires à la détermination de la position possible et qui dépendent du câble haute tension sur lequel se situe le dispositif de détermination qui a émis le signal témoin reçu. Ces informations sont notamment :

- le retard associé au signal témoin reçu,
- de la longueur du câble haute tension ou des câbles hautes tensions parcourue par le signal témoin reçu.

Il est ensuite procédé à la détermination de la distance séparant le poste source 2 et le précurseur de défaut selon la méthode et à l'aide de la formule mathématique décrites précédemment.

Dans l'exemple de la figure 5, les résultats des calculs donnent :

- pour le premier signal témoin émis dans le premier poste HTA/BT final 9, le précurseur de défaut est localisé à une première position possible qui est la position de la zone $Z_D$ de dérivation.
- pour le deuxième signal témoin émis dans le deuxième poste HTA/BT final 11, le précurseur de défaut est localisé à une deuxième position possible qui est la position du précurseur de défaut 10.

Au cours de l'étape (S5) la position du précurseur de défaut dans le câble haute tension est déterminée prenant en compte pour chaque signal témoin reçu la position possible du précurseur de défaut dans le câble haute tension. Pour cela, les principes suivants sont utilisés :

Si le précurseur de défaut est situé entre le poste source 2 et la zone de dérivation, les deux positions possibles sont identiques et sont la position du précurseur de défaut.

Si le précurseur de défaut est situé entre la zone de déviation et un poste HTA/BT final, les deux positions possibles ne sont pas identiques.

La position possible donnée par le poste HTA/BT final « direct » sur la branche duquel est situé le précurseur de défaut est la position du précurseur de défaut.

La position possible donnée par le poste HTA/BT final « indirect » sur la branche duquel n'est pas situé le précurseur de défaut est la position de la zone de dérivation.

Dans l'exemple de la figure 5, on retient la deuxième position possible comme position du précurseur de défaut.

Selon les situations, il est toujours possible de déterminer la position du précurseur de défaut 10.

**Revendications**

1. Procédé de détermination d'une position d'un précurseur de défaut (10) dans un câble haute tension détérioré reliant un premier poste et un deuxième poste, l'un du premier poste et du deuxième poste étant un poste source (2) propre à alimenter le câble haute tension avec un signal haute tension et l'autre du premier poste et du deuxième poste étant un poste secondaire (9) propre à recevoir le signal haute tension, comprenant les étapes suivantes

   (S1) détection par le premier poste d'une première signature d'une anomalie de courant électrique dans le signal haute tension,
   (S2) détection par le deuxième poste d'une deuxième signature de l'anomalie de courant électrique dans le signal haute tension,
   (S3) émission par le deuxième poste d'un signal témoin vers le premier poste dans le câble haute tension, le signal témoin étant émis par le deuxième poste avec un retard prédéterminé à compter d'un instant de détection de la deuxième signature,
   (S4) détection par le premier poste du signal témoin reçu par le premier poste, (S5) détermination de la position du précurseur de défaut dans le câble haute tension, en fonction d'un instant de détection de la première signature par le premier poste et d'un instant de détection du signal témoin par le premier poste,
   le procédé étant **caractérisé en ce que** le retard prédéterminé prend une valeur comprise entre 15% et 50% de la période du signal haute-tension.

2. Procédé selon la revendication 1, dans lequel le câble haute tension comprend trois phases, l'étape (S1) de détection par le premier poste d'une première signature comprenant la mesure de trois signaux électriques alimentant les trois phases, le calcul de la somme des mesures des trois signaux électriques et la comparaison de la somme à un seuil.

3. Procédé selon l'une des revendications 1 ou 2, dans lequel le premier poste est relié à une pluralité de deuxièmes postes via une pluralité de câbles haute tension, chaque câble étant alimenté par un même signal haute tension, l'étape (S1) de détection de la première signature comprenant les sous-étapes suivantes :

   (S1A) détection par le premier poste d'une pluralité de premières signatures de l'anomalie de courant électrique dans les signaux haute tension,
   (S1B) identification, parmi les premières signatures, de la première signature principale représentative d'une irrégularité de courant d'amplitude maximale, de variation initiale maximale et opposée aux autres premières signatures d'irrégularité de courant,
   (S1C) identification, parmi la pluralité de câble haute tension, du câble haute tension détérioré alimenté par le signal haute tension comportant la première signature principale identifiée, et dans lequel la position du précurseur de défaut est déterminée dans le câble haute tension détérioré par la mise en œuvre des étapes (S1) à (S5) avec la première signature principale comme première signature.

4. Procédé selon l'une des revendications 1 à 3, dans lequel le premier poste est relié à une pluralité de deuxièmes postes via une pluralité de câbles haute tension, chaque câble étant alimenté par un même signal haute tension, et les deuxièmes postes sont configurés pour émettre chacun un signal témoin avec une caractéristique prédéterminée qui diffère de caractéristiques prédéterminées des signaux témoins émis par les autres deuxièmes postes, le procédé comprenant, après l'étape (S4) de détection par le premier poste du signal témoin reçu par le premier poste, les étapes additionnelles de

   (P1) détection de la caractéristique prédéterminée du signal témoin,
   (P2) détermination d'une position possible du précurseur de défaut dans le câble haute tension, en fonction d'un instant de détection de la première signature par le premier poste et d'un instant de détection du signal témoin par le premier poste.,
l'étape (S5) de détermination de la position du précurseur de défaut dans le câble haute tension prenant en compte pour chaque signal témoin reçu la position possible du précurseur de défaut dans le câble haute tension.

5. Procédé selon la revendication 4, dans lequel la caractéristique prédéterminée est choisie parmi une valeur particulière de retard, une répartition temporelle entre plusieurs impulsions formant le signal témoin, ou une combinaison de ces caractéristiques.

6. Deuxième dispositif de détermination (D2) de la position d'un précurseur de défaut (10) dans un câble haute tension (7) détérioré reliant deux postes, le deuxième dispositif étant configuré pour mettre en œuvre le procédé selon l'une des revendications 1 à 5 et comprenant un détecteur (92) d'une deuxième signature de l'anomalie de courant électrique dans le signal haute tension, un appareil (98) pour générer et injecter un signal témoin dans le câble haute tension, le deuxième dispositif de détermination (D2) étant configuré pour que la détection de la deuxième signature par le détecteur (92) d'impulsion électromagnétique déclenche l'injection d'un signal témoin par l'appareil (98) avec un retard prédéterminé à compter d'un instant de détection de la deuxième signature, le deuxième dispositif de détermination étant **caractérisé en ce que** le retard prédéterminé prend une valeur comprise entre 15% et 50% de la période du signal haute-tension.

7. Deuxième dispositif selon la revendication 6 dans lequel l'appareil (98) est configuré pour émettre un signal témoin avec une caractéristique prédéterminée parmi une valeur particulière de retard, une répartition temporelle entre plusieurs impulsions formant le signal témoin, ou une combinaison de ces caractéristiques.

8. Système de détermination d'une position d'un précurseur de défaut (10) dans un câble haute tension (7) détérioré reliant un premier poste et un deuxième poste comprenant :

   un deuxième dispositif de détermination (D2) selon l'une des revendications 6 ou 7, et
   un premier dispositif de détermination (D1) de la position d'un précurseur de défaut (10) dans le câble haute tension (7) le premier dispositif étant configuré pour mettre en œuvre le procédé selon l'une des revendications 1 à 5 et comprenant un premier système d'acquisition et de traitement (23) de signal haute-tension passant dans le câble haute tension (7), le premier système d'acquisition et de traitement (23) étant configuré pour détecter la première signature d'une anomalie de courant et un signal témoin, et un premier système de décompte du temps (24) contrôlé par le premier système d'acquisition et de traitement (23) configuré pour déterminer la position d'un précurseur de défaut dans le câble haute tension en fonction d'un instant de détection de la première signature et du signal témoin.

9. Système selon la revendication 8 dans lequel le premier système d'acquisition et de traitement (23) est configuré pour détecter une pluralité de signatures d'une anomalie de courant passant dans une pluralité de câbles haute tension tous reliés à l'un des deux postes, chaque câble étant alimenté par un signal haute tension respectif, et configuré pour détecter parmi cette pluralité de signatures une signature d'irrégularité de courant d'amplitude maximale, de variation initiale maximale et opposée aux autres signatures d'irrégularité de courant.

**Patentansprüche**

1. Verfahren zur Bestimmung einer Position einer Fehlervorstufe (10) in einem beschädigten Hochspannungskabel, das eine erste Station und eine zweite Station verbindet, wobei eine von der ersten Station und der zweiten Station eine Quellstation (2) ist, die dazu geeignet ist, das Hochspannungskabel mit einem Hochspannungssignal zu versorgen, und die andere von der ersten Station und der zweiten Station eine Nebenstation (9) ist, die dazu geeignet ist, das Hochspannungssignal zu empfangen, umfassend die folgenden Schritte

    (S1) Erkennen, durch die erste Station, einer ersten Signatur einer elektrischen Stromanomalie in dem Hochspannungssignal,
    (S2) Erkennen, durch die zweite Station, einer zweiten Signatur der elektrischen Stromanomalie in dem Hochspannungssignal,
    (S3) Senden, durch die zweite Station, eines Kontrollsignals an die erste Station in dem Hochspannungskabel, wobei das Kontrollsignal von der zweiten Station mit einer vorbestimmten Verzögerung ab einem Zeitpunkt des Erkennens der zweiten Signatur gesendet wird,
    (S4) Erkennen, durch die erste Station, des durch die erste Station empfangenen Kontrollsignals,
    (S5) Bestimmen der Position der Fehlervorstufe in dem Hochspannungskabel in Abhängigkeit von einem Zeitpunkt des Erkennens der ersten Signatur durch die erste Station und einem Zeitpunkt des Erkennens des Kontrollsignals durch die erste Station,
wobei das Verfahren **dadurch gekennzeichnet ist, dass** die vorbestimmte Verzögerung einen Wert annimmt, der zwischen 15 % und 50 % der Periode des Hochspannungssignals enthalten ist.

2. Verfahren nach Anspruch 1, wobei das Hochspannungskabel drei Phasen umfasst, wobei der Schritt (S1) des Erkennens, durch die erste Station, einer ersten Signatur das Messen von drei elektrischen Signalen, welche die drei Phasen versorgen, das Berechnen der Summe der Messungen der drei elektrischen Signale und das Vergleichen der Summe mit einem Schwellenwert umfasst.

3. Verfahren nach einem der Ansprüche 1 oder 2, wobei die erste Station über eine Vielzahl von Hochspannungskabeln mit einer Vielzahl von zweiten Stationen verbunden ist, wobei jedes Kabel von einem gleichen Hochspannungssignal versorgt wird, wobei der Schritt (S1) des Erkennens der ersten Signatur die folgenden Teilschritte umfasst:

    (S1A) Erkennen, durch die erste Station, einer Vielzahl von ersten Signaturen der elektrischen Stromanomalie in den Hochspannungssignalen,
    (S1B) Identifizieren, unter den ersten Signaturen, der ersten Hauptsignatur, die eine Stromunregelmäßigkeit mit maximaler Amplitude, maximaler Anfangsschwankung und entgegengesetzt zu den anderen ersten Stromunregelmäßigkeitssignaturen darstellt,
    (S1C) Identifizieren, unter der Vielzahl von Hochspannungskabeln, des beschädigten Hochspannungskabels, das durch das Hochspannungssignal versorgt wird, das die erste identifizierte Hauptsignatur umfasst, und
wobei die Position der Fehlervorstufe in dem beschädigten Hochspannungskabel durch das Durchführen der Schritte (S1) bis (S5) mit der ersten Hauptsignatur als erste Signatur bestimmt wird.

4. Verfahren nach einem der Ansprüche 1 bis 3, wobei die erste Station über eine Vielzahl von Hochspannungskabeln mit einer Vielzahl von zweiten Stationen verbunden ist, wobei jedes Kabel durch ein gleiches Hochspannungssignal versorgt wird, und die zweiten Stationen dazu ausgestaltet sind, jeweils ein Kontrollsignal mit einer vorbestimmten Eigenschaft zu senden, die sich von vorbestimmten Eigenschaften der Kontrollsignale unterscheidet, die von den anderen zweiten Stationen gesendet werden, wobei das Verfahren nach dem Schritt (S4) des Erkennens, durch die erste Station, des durch die erste Station empfangenen Kontrollsignals die folgenden zusätzlichen Schritte umfasst:

(P1) Erkennen der vorbestimmten Eigenschaft des Kontrollsignals,
(P2) Bestimmen einer möglichen Position der Fehlervorstufe in dem Hochspannungskabel in Abhängigkeit von einem Erkennungszeitpunkt der ersten Signatur durch die erste Station und einem Erkennungszeitpunkt des Kontrollsignals durch die erste Station,
wobei der Schritt (S5) des Bestimmens der Position der Fehlervorstufe in dem Hochspannungskabel für jedes empfangene Kontrollsignal die mögliche Position der Fehlervorstufe in dem Hochspannungskabel berücksichtigt.

5. Verfahren nach Anspruch 4, wobei die vorbestimmte Eigenschaft unter einem bestimmten Verzögerungswert, einer zeitlichen Verteilung zwischen mehreren Impulsen, die das Kontrollsignal bilden, oder einer Kombination dieser Eigenschaften gewählt wird.

6. Zweite Vorrichtung (D2) zur Bestimmung der Position einer Fehlervorstufe (10) in einem beschädigten Hochspannungskabel (7), das zwei Stationen verbindet, wobei die zweite Vorrichtung dazu ausgestaltet ist, das Verfahren nach einem der Ansprüche 1 bis 5 durchzuführen, und eine Einrichtung (92) zur Erkennung einer zweiten Signatur der elektrischen Stromanomalie in dem Hochspannungssignal und ein Gerät (98) zum Erzeugen und Einspeisen eines Kontrollsignals in das Hochspannungskabel umfasst, wobei die zweite Bestimmungsvorrichtung (D2) so ausgestaltet ist, dass das Erkennen der zweiten Signatur durch die Einrichtung (92) zur Erkennung elektromagnetischer Impulse das Einspeisen eines Kontrollsignals durch das Gerät (98) mit einer vorbestimmten Verzögerung ab einem Erkennungszeitpunkt der zweiten Signatur auslöst, wobei die zweite Bestimmungsvorrichtung **dadurch gekennzeichnet ist, dass** die vorbestimmte Verzögerung einen Wert annimmt, der zwischen 15 % und 50 % der Periode des Hochspannungssignals enthalten ist.

7. Zweite Vorrichtung nach Anspruch 6, wobei das Gerät (98) dazu ausgestaltet ist, ein Kontrollsignal mit einer vorbestimmten Eigenschaft unter einem bestimmten Verzögerungswert, einer zeitlichen Verteilung zwischen mehreren Impulsen, die das Kontrollsignal bilden, oder einer Kombination dieser Eigenschaften zu senden.

8. System zur Bestimmung einer Position einer Fehlervorstufe (10) in einem beschädigten Hochspannungskabel (7), das eine erste Station und eine zweite Station verbindet, umfassend:

eine zweite Bestimmungsvorrichtung (D2) nach einem der Ansprüche 6 oder 7, und
eine erste Vorrichtung (D1) zur Bestimmung der Position einer Fehlervorstufe (10) in dem Hochspannungskabel (7), wobei die erste Vorrichtung dazu ausgestaltet ist, das Verfahren nach einem der Ansprüche 1 bis 5 durchzuführen, und umfassend
ein erstes System (23) zur Erfassung und Verarbeitung von Hochspannungssignalen, die das Hochspannungskabel (7) durchqueren, wobei das erste Erfassungs- und Verarbeitungssystem (23) dazu ausgestaltet ist, die erste Signatur einer Stromanomalie und ein Kontrollsignal zu erkennen, und
ein erstes Zeitrechnungssystem (24), das von dem ersten Erfassungs- und Verarbeitungssystem (23) gesteuert wird und dazu ausgestaltet ist, die Position einer Fehlervorstufe in dem Hochspannungskabel in Abhängigkeit von einem Erkennungszeitpunkt der ersten Signatur und des Kontrollsignals zu bestimmen.

9. System nach Anspruch 8, wobei das erste Erfassungs- und Verarbeitungssystem (23) dazu ausgestaltet ist, eine Vielzahl von Signaturen einer Stromanomalie zu erkennen, die eine Vielzahl von Hochspannungskabeln durchqueren, die alle mit einer der zwei Stationen verbunden sind, wobei jedes Kabel durch ein jeweiliges Hochspannungssignal versorgt wird, und dazu ausgestaltet ist, unter dieser Vielzahl von Signaturen eine Stromunregelmäßigkeitssignatur mit maximaler Amplitude, maximaler Anfangsschwankung und entgegengesetzt zu den anderen Stromunregelmäßigkeitssignaturen zu erkennen.

## Claims

1. A method of determining a position of a fault precursor (10) in a deteriorated high-voltage cable connecting a first station and a second station, one of the first station and the second station being a source station (2) adapted to supply the high-voltage cable with a high-voltage signal and the other of the first station and the second station being a secondary station (9) adapted to receive the high-voltage signal, comprising the following steps

(S1) detection by the first station of a first signature of an electric current anomaly in the high-voltage signal,
(S2) detection by the second station of a second signature of the electric current anomaly in the high-voltage signal,
(S3) emission by the second station of a witness signal to the first station in the high-voltage cable, the witness signal being emitted by the second station with a predetermined delay from an instant of detection of the second signature, (S4) detection by the first station of the control signal received by the first station,

(S5) determination of the position of the fault precursor in the high-voltage cable, as a function of a time of detection of the first signature by the first station and a time of detection of the warning signal by the first station, the method being **characterized in that** the predetermined delay takes on a value of between 15% and 50% of the period of the high-voltage signal.

2. A method according to claim 1, in which the high-voltage cable comprises three phases, the step (S1) of detection by the first station of a first signature comprising measuring three electrical signals feeding the three phases, calculating the sum of the measurements of the three electrical signals and comparing the sum with a threshold.

3. Method according to one of claims 1 or 2, in which the first station is connected to a plurality of second stations via a plurality of high-voltage cables, each cable being fed by the same high-voltage signal, the step (S1) of detecting the first signature comprising the following sub-steps :

   (S1A) detection by the first station of a plurality of first signatures of the electric current anomaly in the high-voltage signals,
   (S1B) identification, among the first signatures, of the first main signature representative of a current irregularity of maximum amplitude, maximum initial variation and opposite to the other first current irregularity signatures,
   (S1C) identification, among the plurality of high-voltage cables, of the deteriorated high-voltage cable fed by the high-voltage signal comprising the identified first principal signature, and
   in which the position of the fault precursor is determined in the damaged high-voltage cable by carrying out steps (S1) to (S5) with the first main signature as the first signature.

4. A method according to any one of claims 1 to 3, in which the first station is connected to a plurality of second stations via a plurality of high-voltage cables, each cable being supplied with a same high-voltage signal, and the second stations are each configured to emit a test signal with a predetermined characteristic which differs from predetermined characteristics of the test signals emitted by the other second stations, the method comprising, after the step (S4) of detection by the first station of the test signal received by the first station, the additional steps of

   (P1) detecting the predetermined characteristic of the control signal,

(P2) determining a possible position of the fault precursor in the high-voltage cable, as a function of a time of detection of the first signature by the first station and a time of detection of the witness signal by the first station,

the step (S5) of determining the position of the fault precursor in the high-voltage cable, taking into account the possible position of the fault precursor in the high-voltage cable for each control signal received.

5. Method according to claim 4, in which the predetermined characteristic is chosen from a particular delay value, a time distribution between several pulses forming the control signal, or a combination of these characteristics.

6. A second device (D2) for determining the position of a fault precursor (10) in a damaged high-voltage cable (7) connecting two substations, the second device being configured to implement the method according to one of claims 1 to 5 and comprising a detector (92) of a second signature of the electric current anomaly in the high-voltage signal, an apparatus (98) for generating and injecting a witness signal into the high-voltage cable, the second determination device (D2) being configured so that detection of the second signature by the electromagnetic pulse detector (92) triggers injection of a test signal by the apparatus (98) with a predetermined delay from an instant of detection of the second signature, the second determination device being **characterized in that** the predetermined delay takes a value of between 15% and 50% of the period of the high-voltage signal.

7. Second device according to claim 6 in which the device (98) is configured to emit a control signal with a predetermined characteristic from among a particular delay value, a time distribution between several pulses forming the control signal, or a combination of these characteristics.

8. System for determining a position of a fault precursor (10) in a deteriorated high-voltage cable (7) connecting a first station and a second station, comprising :

   a second determination device (D2) according to one of claims 6 or 7, and
   a first device (D1) for determining the position of a fault precursor (10) in the high-voltage cable (7), the first device being configured to implement the method according to one of claims 1 to 5 and comprising
   a first acquisition and processing system (23) for the high-voltage signal passing through the high-voltage cable (7), the first acquisition and processing system (23) being configured to detect the first signature of a current anomaly and a test signal n, and

a first time-counting system (24) controlled by the first acquisition and processing system (23) configured to determine the position of a fault precursor in the high-voltage cable as a function of an instant of detection of the first signature and the witness signal.

9. A system according to claim 8 in which the first acquisition and processing system (23) is configured to detect a plurality of signatures of a current anomaly passing through a plurality of high-voltage cables all connected to one of the two substations, each cable being supplied with a respective high-voltage signal, and configured to detect among this plurality of signatures a current irregularity signature of maximum amplitude, maximum initial variation and opposite to the other current irregularity signatures.

## Figure 1

## Figure 2

EP 3 798 648 B1

## Figure 3

P

détection par le premier poste d'une première signature d'une anomalie de courant électrique dans le signal haute tension — S1

détection par le premier poste d'une pluralité de premières signatures de l'anomalie de courant électrique — S1A

identification, parmi les premières signatures, de la première signature principale — S1B

identification du câble haute tension détérioré — S1C

détection par le deuxième poste d'une deuxième signature de l'anomalie de courant électrique dans le signal haute tension — S2

émission d'un signal témoin du deuxième poste vers le premier poste avec un retard prédéterminé — S3

détection par le premier poste du signal témoin reçu par le premier poste — S4

détection de la caractéristique prédéterminée du signal témoin — P1

sélection du signal témoin en fonction de la caractéristique prédéterminée — P2

détermination de la position du précurseur en fonction d'un instant de détection de la première signature et d'un instant de détection du signal témoin — S5

# Figure 4

# Figure 5

FIG. 5

## RÉFÉRENCES CITÉES DANS LA DESCRIPTION

**Documents brevets cités dans la description**

- US 5682100 A
- US 5416418 A

- JP S61225666 A